# EUROPEAN PATENT SPECIFICATION

(11) **EP 3 125 307 B1**
(45) Date of publication and mention of the grant of the patent: **25.03.2020**
(21) Application number: 14887491.0
(22) Date of filing: 30.12.2014
(51) Int. Cl.: H01L 31/042, H01L 31/0392, H01L 31/043, H01L 31/0465, H01L 51/44

(54) **FLEXIBLE DEVICE**
FLEXIBLE VORRICHTUNG
DISPOSITIF FLEXIBLE

(30) Priority: 28.03.2014 KR 20140037062
(43) Date of publication of application: 01.02.2017
(73) Proprietor: Kolon Industries, Inc., Seoul 07793 (KR)
(72) Inventor: CHOI, Kwan Min, Yongin-si Gyeonggi-do 446-797 (KR); HAHN, Jung Seok, Yongin-si Gyeonggi-do 446-797 (KR); KIM, Eun Uk, Yongin-si Gyeonggi-do 446-797 (KR); CHOI, Yoon Young, Yongin-si Gyeonggi-do 446-797 (KR); KIM, Kwang Su, Yongin-si Gyeonggi-do 446-797 (KR); KU, Ja Ram, Yongin-si Gyeonggi-do 446-797 (KR)
(74) Representative: Ter Meer Steinmeister & Partner
(86) International application number: PCT/KR2014/013041
(87) International publication number: WO 2015/147423

(56) References cited:
- EP-A1- 2 012 364
- WO-A1-2005/086255
- WO-A1-2014/003187
- US-A1- 2011 036 448
- US-A1- 2011 298 871
- US-A1- 2012 318 331
- US-A1- 2012 318 331
- US-A1- 2013 118 558
- US-A1- 2013 255 744
- US-A1- 2014 024 166
- US-B1- 6 380 477
- US-B1- 6 380 477

## Description

### [Technical Field]

The present invention relates to a flexible device which has a structure enabling easy bonding between unit flexible devices.

### [Background Art]

As various forms of devices are developed and applied to various fields, demand for flexible devices is increasing. Recently, as wearable devices such as smart glasses are known and exposed to the public, the importance thereof is further increasing. Renovated wearable device products are launched in various fields of companies including technology-leading companies of the information & communication technology (ICT) as well as sporting goods manufacturers. A wearable device, which is a next-generation smart device after the smartphone era, is chosen as a novel business line by various business operators.

A wearable device refers to an electronic device which is worn on the human body. However, an electronic device does not refer to an electronic device which is simply worn on the human body, like a simple accessory, but refers to an electronic device which can be communicated with a user at the closest position to the body of the user. The wearable device has an advantage of continuously collecting detailed information about the surrounding environment or physical change of the user in-real time. However, the wearable device is inapplicable as fixed shapes of devices such as glasses because it is generally worn or mounted on curved sites such as curved human body sites or building columns, and materials for flexible devices require flexibility and high heat resistance because the flexible device is formed at high temperature. Specifically, a variety of forms including heat-resistant films such as polyimide, metal foils offering easy shape change, or forms having an outer part treated with a resin based on heat-resistant glass fiber-based resins are reviewed and applied. Recently, attempts to produce flexible devices using thin glass are continuously underway.

The same applies to the new and renewable energy field. Recently, solar cells attract much attention as an alternative new and renewable energy to reduce CO₂ and protect the environment. In particular, solar cells are already commercialized and applied as novel clean energy based on great research and development in Japan, Germany, Europe and the United States. Currently commercialized solar cells are mostly Si, CdTe and CIGS solar cells based on inorganic semiconductor technology. However, such an inorganic solar cell has an advantage of high energy conversion efficiency of 15 to 20%, but has a drawback of a high-energy and high-cost production method using high-temperature and vacuum semiconductor processes. In addition, the inorganic solar cell has potential problems including resource depletion of materials used for semiconductor processes, obtainment of rare inorganic materials, and environmental pollution caused by harmful process substances.

Meanwhile, polymer solar cells can realize a large-area, lightweight and flexible structure because a module can be produced on a plastic film by a printing process at 150°C or less. In particular, energy used to produce solar cells can be reduced using roll-to-roll equipment which is the key of printed electronics technology, and mass-production is possible and production costs can be remarkably reduced due to short production time. In addition, polymer solar cells can be mass-produced in a customized form, can be freely applied to portable electronic devices, clothing, leisure goods and the like, and the amount of supplied new and renewable energy can be increased by converting individuals into prosumers (production + consumer) who become subjects of energy consumption and production.

As such, as various flexible devices and various application methods are researched and developed, the sizes of flexible devices should be varied depending on applied shape and position, and areas of applied sites. In this case, when different flexible devices are produced depending on applied shape and position, and areas of applied sites, production efficiency is inevitably deteriorated. In addition, flexible devices should absorb light in a large area to maximize efficiency thereof, and thus flexible devices require large areas. However, in this case, various forms of customized products are needed depending on various use applications and purposes, which inevitably causes problems such as deteriorated production efficiency, high-cost structures and renovation difficulties.

Recently, in order to solve these problems, unit flexible devices are produced and then connected to realize large area. In this case, advantageously, production efficiency can be maximized by producing unit flexible devices, large area can be realized by bonding (binding) unit flexible devices, or joined forms can be variably realized according to the desired shape, and when a certain unit flexible device has deteriorated performance or ceases to work after large-area realization, original performance can be secured again by changing only the certain unit flexible device.

However, conventional bonding methods of unit flexible devices such as terminal coupling or volt coupling have problems in that bonding sites are highly visible, there is inconvenience in extending the bonding site to a desired shape due to thick bonding site, films are readily damaged because they should be opened to form bonding parts and bonding parts should be formed in respective unit organic devices.

The following documents describe the teaching of the prior art: KR 1020110037679 A, WO 2014/003187 A1, US 2014/0024166 A1 and US 6380477 B1.

### [Disclosure]

### [Technical Problem]

Therefore, it is one object of the present invention to provide a flexible device having a structure offering easy bonding between unit flexible devices.

It is another object of the present invention to provide a flexible device module including two or more flexible devices including the flexible device connected by conductive attachment.

### [Technical Solution]

The subject matter of the present invention is defined in claim 1.

The conductive bonding layer may be disposed on the first or second current collector.

In addition, the conductive bonding layer may have a shape selected from the group consisting of a film, a stripe and an island.

In addition, the conductive material may include at least one selected from the group consisting of a metal powder, a carbonaceous material, metal oxide, a conductive polymer and a derivative thereof, a magnetic material and a mixture thereof.

In addition, the bonding material may be selected from the group consisting of an epoxy resin, a polyester resin, an acrylic resin, a phenolic resin, a vinyl resin, polyimide, polybenzimidazole, a silicone-based resin, a urethane resin, a melamine urea resin and a mixture thereof. The conductive bonding layer may be formed on the guide electrode.

In addition, the flexible device may further include an oxygen and/or moisture barrier layer on the unit cell, wherein the first and second current collectors are exposed from the oxygen and/or moisture barrier layer.

In addition, the substrate may be a flexible substrate selected from the group consisting of a metal foil, an inorganic thin film, a polymer film, a fibrous material, and a composite of a glass fiber and a polymer.

In another aspect of the present invention, provided is a flexible device module including two or more flexible devices including the flexible device, wherein the flexible devices are electrically bonded by a conductive bonding layer.

The flexible device may include conductive bonding layers on the respective first and second current collectors, and one of the conductive bonding layers formed on the first and second current collectors may include a magnetic material and the other conductive bonding layer may include a conductive material including a metal powder or a metal thin film.

The flexible device may include conductive bonding layers disposed on the respective first and second current collectors, and one of the conductive bonding layers formed on the first and second current collectors may include a conductive material and a bonding material including an adhesive agent or sticking agent, and the other conductive bonding layer may include a conductive material and a release agent.

In addition, the flexible devices may be bonded in series or in parallel.

In addition, the bonding between the flexible devices may be removable temporary bonding.

Other details of embodiments of the present invention are incorporated in the Detailed Description of the Invention described below.

### [Effects of the Invention]

The flexible device according to the present invention provides easy bonding between unit flexible devices by a conductive bonding layer formed on a current collector in the device. Accordingly, production efficiency can be improved by standardization of unit flexible devices and flexible device modules having various voltages and currents can be attached or applied depending on the applied sites or areas without inconvenience of re-production of electrode patterns, slot-die cores, or screen substrates for metal electrodes according to various specifications of various electronic devices using flexible devices. In addition, when a certain flexible device does not work or has a deteriorated performance, it can be easily changed owing to easy removal and the difference in thickness between the bonding part and other parts of the flexible device is relatively small. Accordingly, the flexible device can be applied to a variety of fields due to less shape or design limitation of module which can be produced depending on application.

### [Description of Drawings]

The above and other objects, features and other advantages of the present invention will be more clearly understood from the following detailed description taken in conjunction with the accompanying drawings, in which:
FIG. 1 is a sectional view illustrating a structure of a flexible device according to an embodiment of the present invention and a plan view illustrating the solar cell;
FIGS. 2A to 2C show a configuration of a conductive bonding layer formed in various shapes in flexible devices according to different embodiments of the present invention; and
FIG. 3 is a schematic view illustrating a configuration of a flexible device module according to another embodiment of the present invention.

### [Best Mode]

The present invention covers various alternatives and various embodiments and will be described in more detail with reference to certain embodiments. However, the certain embodiments should be not construed as limiting the scope of the present invention and it should be appreciated that the present invention includes all modifications, alterations, equivalents and substituents within the scope of the present invention.

The present invention is characterized in that different two unit flexible devices are temporarily or permanently bonded by electrical signal or current by forming a conductive bonding layer on first and second current collectors disposed at both side ends of a substrate in the production of a flexible device.

That is, the flexible device according to an embodiment of the present invention includes a substrate, a unit cell being disposed on the substrate and generating an electric energy, and first and second current collectors disposed at outer side surfaces of the unit cell on the substrate, wherein at least one of the first and second current collector includes a conductive material and a conductive bonding layer including any one bonding material of an adhesive agent and a sticking agent.

Specifically, the conductive bonding layer may be disposed on the first or second current collector, more specifically, on the entire or partial surface of the first or second current collector.

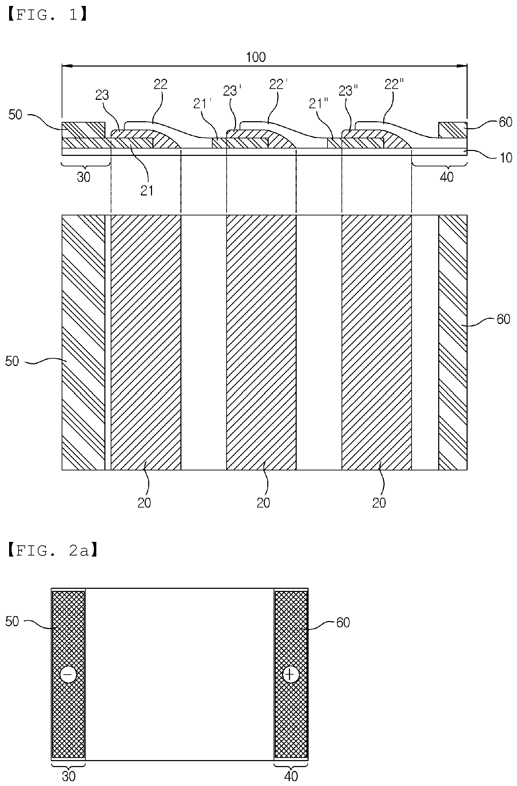

FIG. 1 shows an example of a flexible device according to an embodiment of the present invention. More specifically, FIG. 1 is a schematic sectional view illustrating a solar cell having a structure in which a conductive bonding layer is formed on a current collector and a plan view illustrating the solar cell. FIG. 1 is provided only for illustration of the present invention and the present invention is not limited thereto.

Referring to FIG. 1, the flexible device according to the present invention includes a substrate 10, a unit cell 20 disposed on the substrate, first and second current collectors 30 and 40 disposed at outer side surfaces of the unit cell on the substrate, and conductive bonding layers 50 and 60 disposed on at least one of the first and second current collectors.

Specifically, regarding the flexible device, the substrate 10 functions to support the unit cell which converts light energy into electric energy, and the first and second current collectors which transfer the converted electric energy to the outside. Any substrate may be used without particular limitation so long as it is flexible and the shape thereof can be changed so that it can be applied to ordinary flexible devices.

Specifically, the substrate 10 includes: a metal foil such as aluminum; an inorganic thin film including quartz, glass or the like; a polymer film such as polyethylene terephthalate (PET), polyethylene naphthalate (PEN), polycarbonate (PC), polystyrene (PS), polypropylene (PP), polyimide (PI), polyethylene sulfonate (PES), polyoxymethylene (POM), polyetheretherketone (PEEK), polyether sulfone (PES) or polyether imide (PEI); a fibrous material; or a composite of fiberglass and a polymer. Of them, the substrate 10 more preferably includes a polymer or PET film which is flexible, has high chemical stability, mechanical strength and transparency and can be easily converted into various shapes.

In addition, when the flexible device allows light to be transmitted through a substrate such as a solar cell, the substrate 10 may require transparency. In this case, the substrate 10 preferably has a transmittance of at least 70%, preferably at least 80% at a visible light wavelength of about 380 to 780 nm.

The unit cell 20 of the flexible device is disposed on the substrate 10.

The unit cell 20 is the minimum unit which generates electric energy in the flexible device and may have a variety of structures depending on the type of the flexible device.

Specifically, the unit cell 20 includes first and second electrodes 21 and 22 facing each other on the substrate 10, and an active layer 23 disposed between the first and second electrodes. There is no particular limitation as to materials for forming the first and second electrodes and the active layer so long as the materials are used for ordinary flexible devices.

For example, when the flexible device is a solar cell, the first electrode functions as a channel, enabling light having passed through the substrate to reach a photoactive layer, and includes a conductive material which has high transparency, a high work function of about 4.5eV or more and low resistance. Specific examples of the conductive material include tin-doped indium oxide (ITO), fluorine-doped tin oxide (FTO), transparent oxides such as ZnO-Ga₂O₃, ZnO-Al₂O₃, and SnO₂-Sb₂O₃, conductive polymers, organic transparent electrodes such as graphene thin films, graphene oxide thin films, or carbon nanotube thin films, and organic-inorganic hybrid transparent electrodes such as metal-adhered carbon nanotube thin films.

In addition, the second electrode includes a material having a low work function and may specifically be magnesium, calcium, sodium, potassium, titanium, indium, yttrium, lithium, aluminum, silver, tin, lead, stainless steel, copper, tungsten, silicon or the like.

A p-n junction is required to convert light energy into electric energy in a solar cell. When light energy is applied to an organic thin film solar cell, a donor material generally absorbs light to form an electron-hole pair (exciton) being in an excited energy state. While diffusing in any direction, this exciton meets the boundary with an acceptor material and then splits into an electron and a hole. That is, an acceptor material having a high electron affinity rapidly attracts the electron to induce charge separation and the hole remaining in the donor layer moves to an anode due to internal electric field formed by the difference in work function between two electrodes and the difference in concentration of accumulated charges, whereas the electron moves to a cathode along the inside of the acceptor layer and is thus collected. The collected charge finally flows in the form of a current by an exterior circuit. This phenomenon is referred to as a photovoltaic effect. As described above, light absorption and charge separation in the photoactive layer of the organic solar cell are caused by a bulk heterojunction structure in which a donor and an acceptor are blended. The bulk heterojunction has a structure in which a donor material and an acceptor material are blended in an area of 10 nm or less, thus advantageously offering several hundred-fold or more larger donor/acceptor boundary area, as compared to a bilayer structure in which a donor and an acceptor have a single boundary. This functions to further increase charge separation possibility and light absorption efficiency by micro light scattering. This is only a unique structure of an organic thin film solar cell which is completely distinguished from a p-n junction structure of a conventional inorganic-based solar cell.

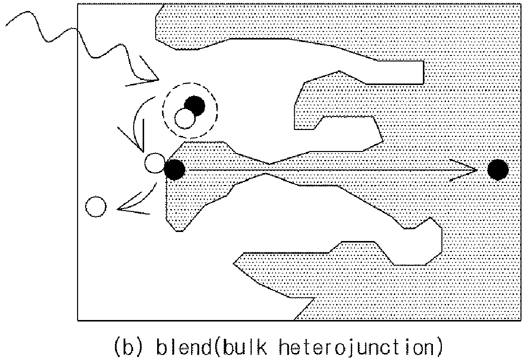

In addition, the active layer may be a photoactive layer which includes a p-n junction in which a p-junction layer is bonded to an n-junction layer.

A plurality of anion and electron carriers are present in the p-junction layer and a plurality of cation and hole carriers are present in the n-junction layer. Accordingly, anions present in the p-junction layer and cations present in the n-junction layer are moved by the p-n junction to the boundary of the p-n junction. Meanwhile, the photoactive layer has almost no free electrons and thus has semiconductor characteristics, but, when it absorbs light energy from the outside, free energy of electrons confined in the nucleus of atoms is increased and electrons are excited. Such an excited electron is converted into a free electron. This phenomenon is referred to as a photovoltaic effect. Accordingly, when light energy is transferred to the photoactive layer from the outside, free electron is generated and at the same time, passes through the boundary of the p-n junction and is collected toward the n-junction layer. When electrons are collected, electricity flows upon connection of a conductive wire to the p-junction layer and the n-junction layer.

Accordingly, in the case of an inorganic solar cell, polarities of the first electrode layer and the second electrode layer provided at both ends of one solar cell module depend on the directions of the p-junction layer and the n-junction layer respectively present in the photoactive layer.

The unit cell 20 including the first and second electrodes 21 and 22 and the active layer 23 as one unit may be formed singly or in plural on the substrate 10.

In this case, the second electrode layer in one unit cell is electrically connected to the first electrode layer of the adjacent unit cell. As a result, a plurality of unit cells formed in one flexible device are electrically connected in series. In addition, electric energy generated in each unit cell is moved to the first and second current collectors 30 and 40 disposed at outer ends of the outermost unit cell by an electric connection member (not shown) connected to upper and lower ends of the unit cell.

Meanwhile, because performance of the unit cell 10 may be deteriorated when the unit cell 10 comes in contact with oxygen or air, an oxygen and/or air barrier (permeation-preventing) layer (not shown) may be optionally further formed to cover the unit cell to prevent contact between the unit cell and oxygen and/or air.

Any material for forming the oxygen and/or air barrier layer may be used without particular limitation so long as it is generally used to form films for preventing contact between the unit cell and oxygen and/or air in a flexible device. Specifically, the material for forming the oxygen and/or air barrier layer may be metal oxide such as silicon oxide or aluminum oxide, or a polymer such as polyethylene terephthalate.

In addition, the oxygen and/or air barrier layer (not shown) can be formed by an ordinary film formation method according to used material. Specifically, when a polymer such as polyethylene terephthalate is used, the layer can be formed by a roll-to-roll process.

In addition, when, in the flexible device, the first and second electrodes 21 and 22 extend from the outermost unit cell on the substrate 10 and an oxygen and/or moisture barrier film (not shown) is formed, first and second current collectors 30 and 40 exposed from the oxygen and/or moisture barrier film are present. The exposed first and second current collectors have different electric polarities of (+) or (-), depending on the polarity of the extended electrode, and function to collect electric energy generated in the unit cell and transfer the same to the outside by a separate electric connection member (not shown).

The first and second current collectors 30 and 40 include the same material as the material for forming the first or second electrodes because they respectively extend from the first and second electrodes constituting the unit cell. Although the first and second current collectors 30 and 40 extend from the first and second electrodes, they may be separately attached to outer surfaces of the first and second electrodes so that they can function the same as the first and second current collectors. This structure in which the first and second current collectors are attached to the first and second electrodes is referred to as a guide electrode. The guide electrode may have a variety of shapes and may have a " 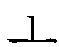 " shape in consideration of connection efficiency to first and second electrodes and bonding efficiency for bonding to another unit flexible device.

A conductive bonding layer is disposed on at least one of the first and second electrodes.

The conductive bonding layer electrically connects two different flexible devices and allows electrical signal or current to flow. Accordingly, the conductive bonding layer includes a conductive material for electric conduction and a bonding material for forming bonding by adhesion, sticking or magnetism.

The conductive material may be a metal powder or foil (for example, silver, copper, aluminum, nickel, lead or the like); a carbonaceous material (for example, carbon black or graphite, graphene, carbon nanotube (CNT) or the like); metal oxide (for example, indium oxide (In₂O₃), indium tin oxide (ITO), titanium oxide (TiO₂), zinc oxide (ZnO), antimony tin oxide (ATO) or the like); a conductive polymer or a derivative thereof (for example, doped polyethylene, polypyrrole, polythiophene, doped poly(3,4-ethylenedioxythiophene) (PEDOT) or the like); or a magnetic material (for example, ferrite or the like).

In addition, the bonding material may be an adhesive agent or a sticking agent such as an epoxy resin, a polyester resin, an acrylic resin, a phenolic resin, a vinyl resin, polyimide, polybenzimidazole, a silicone-based resin, a urethane resin, a melamine urea resin or the like.

A content ratio between the conductive material and the bonding material can be suitably controlled depending on the application of the flexible device and specifically, the conductive material is preferably used in an amount of 20 to 50 parts by weight, with respect to 100 parts by weight of the bonding material.

The carbonaceous material used as a conductive material for the formation of the conductive bonding layer exhibits excellent electrical conductivity, but turns black when formed to a predetermined thickness or more. Accordingly, when a carbonaceous material is used for flexible devices requiring transparency, preferably, the content thereof is suitably controlled.

In addition, since a conductive polymer such as doped PEDOT is applied to an ordinary polymer solar cell, a process for forming a conductive bonding layer is advantageous, as compared to other conductive materials.

In addition, when a magnetic material such as ferrite as a conductive material for forming the conductive bonding layer is used, or a sticking agent is used as the bonding material, temporary bonding which can be separated again, if necessary, can be formed.

In the case of the sticking agent, when removal (separation) is conducted within a short time, easy removal is possible, but when long time passes after bonding, or bonding is conducted by a strong pressure, or the sticking agent is hardened by application of heat or light after bonding, removal may not be easy. In this case, a release layer made of a mixture of a release agent ingredient such as silicone (for example, Burim Chemical Co. Ltd., GR-828 or the like) with an electrically conductive material is preferably applied to a conductive bonding layer of another flexible device which is connected to the flexible device to which the sticking agent is applied. In this case, more preferably, the conductive material and the release agent are mixed in the same content because easy release is obtained after adhesion and current and voltage drop can be reduced at attachment sites. This method may be partially applied to an adhesive agent which is not relatively readily detached again.

Meanwhile, when temporary bonding is formed using a magnetic material, one flexible device may include an electrically conductive layer including a magnetic material and another flexible device may include an electrically conductive layer including a metal powder or a metal thin film, thereby offering bonding and removal by magnetism.

In addition, when a sticking agent or an adhesive agent is used, a conductive bonding layer may be formed on only one current collector of two unit flexible devices in need of connection. However, when a magnetic material is used, a conductive bonding layer is preferably formed on both of first and second current collectors of two flexible devices to be bonded.

The conductive bonding layer may have a sheet or film shape that covers the entire surface of the first or second current collector, or may have a stripe or island shape that covers a partial surface thereof. When the conductive bonding layer has the island shape, it may have a variety of shapes such as a diamond or circle shape. A flexible device, in particular, a polymer solar cell or an OLED may be seriously damaged and have a shortened lifespan when the unit cell contacts oxygen and/or moisture. Accordingly, more preferably, the conductive bonding layer has a sheet or film shape covering the first or second current collector to reduce parts of the first and second current collectors exposed to the outside as possible and function as an oxygen and/or moisture barrier film.

FIGS. 2A to 2C show a configuration of a conductive bonding layer formed in various shapes in a flexible device according to an embodiment of the present invention.

When the film-type conductive bonding layer shown in FIG. 2A is formed on each of the first and second current collectors, unit flexible devices can be connected in series or in parallel.

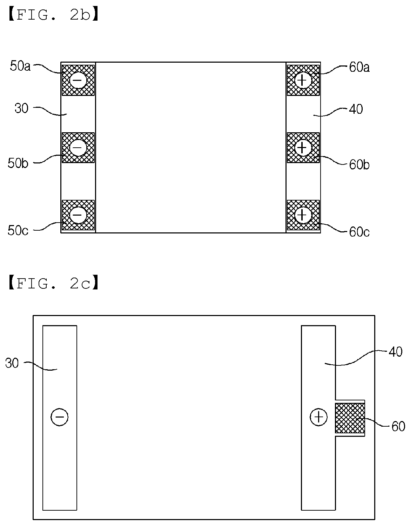

In addition, as shown in FIG. 2B, the conductive bonding layer may be formed in a horizontal stripe shape on the first and second current collectors 30 and 40. In this case, both of connection in series and in parallel are possible by conductive bonding layers 50a, 50c, 60a and 60c formed at fourth edges of the unit flexible device. Only connection in series is possible between unit flexible devices by conductive bonding layers 50b and 60b formed in only the center of the first and second current collectors.

FIG. 2C shows a case in which a current collector including a guide electrode, on which a conductive bonding layer is formed, has a " 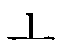 " shape and the conductive bonding layer is formed on a protrusion part of the current collector. In this case, connection in series and connection in parallel between unit flexible devices are both possible depending on the position of the conductive bonding layer.

Preferably, the conductive bonding layer is formed under position and shape conditions suitably controlled depending on the connection method between the unit flexible devices.

In addition, the conductive bonding layer can be formed by applying a composition for forming a conductive bonding layer, prepared by mixing the conductive material with the bonding material, by a method such as bar coating, roll coating, anilox coating, or screen printing, followed by curing or drying.

The flexible device having a structure described above may be produced by a method including forming a unit cell on a substrate and forming a conductive bonding layer on at least one of first and second current collectors disposed at both side ends of the unit cell on the substrate.

Specifically, in the first step, a unit cell of a flexible device is formed on the substrate.

The substrate and the unit cell of the flexible device have been described above and a method of forming the unit cell on the substrate may also be carried out by an ordinary method of forming a unit cell. In addition, the unit cell may include one or more unit cells.

In the second step, the conductive bonding layer is formed.

Specifically, the conductive bonding layer is formed on first and second current collectors respectively extended and exposed from the first and second electrodes of the outermost unit cell formed on the substrate.

In this case, when the flexible device has a structure in which an oxygen and/or moisture barrier film is further formed on the unit cell, forming an oxygen and/or moisture barrier film on the unit cell may be further conducted before formation of the conductive bonding layer.

Specifically, a release film is formed on the first and second current collectors extended and exposed from the first and second electrodes of the outermost unit cell formed on the substrate, and an oxygen and/or moisture barrier film is formed such that it covers the first and second current collectors provided with the unit cell and the release film.

There is no particular limitation as to the release film so long as it has suitable adhesion and release properties to the first and second current collectors. Specifically, a silicone film, a silicone-coated polymer film or the like may be used. When the release film is formed on the first and second current collectors, first and second current collectors are not bonded upon bonding between the flexible substrate and the oxygen and/or moisture barrier film and then, the non-bonded oxygen and/or moisture barrier film part is removed upon cutting into the unit flexible device so that the first and second current collectors can be exposed to the outside.

In addition, there is no particular limitation as to the oxygen and/or moisture barrier film so long as it is used to prevent permeation of oxygen and/or moisture into the unit cell in an ordinary flexible device. The formation method thereof has been described above.

Then, after the oxygen and/or moisture barrier film in the unit cell is shielded with a masking tape or the like to expose only at least one of the first and second current collectors, a composition for forming the conductive bonding layer is applied, cured and dried to form the conductive bonding layer.

The flexible device produced by the afore-mentioned method provides easy bonding between unit flexible devices by the conductive bonding layer formed on any one of the first and second current collectors. Accordingly, production efficiency can be improved by standardization of unit flexible devices and flexible device modules having various voltages and currents can be attached or applied depending on the applied sites or areas without inconvenience of re-production of electrode patterns, slot-die cores, or screen substrates for metal electrodes according to various specifications of various electronic devices using flexible devices. In addition, when a certain flexible device does not work or has a deteriorated performance, it can be easily changed owing to easy removal and the difference in thickness between the bonding part and other parts of the flexible device is relatively small. Accordingly, the flexible device can be applied to a variety of fields due to less shape or design limitation of module which can be produced depending on application.

In addition, in another aspect, the present invention is directed to a flexible device module including two or more flexible devices including the flexible device connected by the conductive bonding layer.

The flexible devices may be connected in series or in parallel with respect to the flexible device acting as a basis.

In this case, when unit organic devices are connected in series according to electrical conductivity, voltage is increased and an increment is proportional to the number of connected unit organic devices. In this case, current is maintained. In addition, when unit organic devices are connected in parallel, current is increased and an increment is proportional to the number of connected unit organic devices. In this case, voltage is maintained.

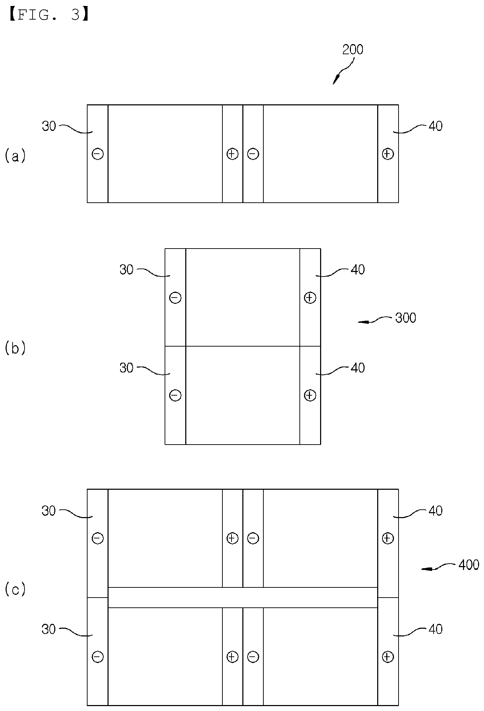

FIG. 3 is a schematic view illustrating a configuration of a solar cell module including unit solar cells bonded by various methods, as an example of a flexible device module. FIG. 3A shows an in-series connection structure, FIG. 3B shows an in-parallel connection structure and FIG. 3C shows a combination structure of in-series connection and in-parallel connection.

In another aspect, the present invention is directed to a method of bonding a flexible device using a conductive bonding layer.

The flexible device and the conductive bonding layer have been described above.

The method of bonding the flexible device may be permanent or temporary bonding which can be removed, if necessary.

With the aforementioned bonding method, a variety of sizes of flexible device modules can be produced. By providing a bonding part having an electrically conductive layer using a coating method for bonding the unit flexible devices, bonding is possible only by a simple process of bonding using an applied pressure in need of bonding. In a case of using a sticking agent or a magnetic material, when a certain unit flexible device normally does not work in the entire flexible device module, the unit flexible device can be easily changed owing to easy removal.

The method of bonding the flexible device may be applied to logic integrated circuits (ICs), central processing units (CPUs), memories, digital signal processors (DSPs), sensors, actuators, communication devices, and at least one semiconductor device including a semiconductor thin film, for example, organic light emitting diodes, organic field-effect transistors, inorganic thin film transistors, and organic or inorganic solar cells.

Hereinafter, embodiments according to the present invention will be described in detail to such an extent that a person having ordinary knowledge in the art field to which the invention pertains can easily carry out the invention. However, the present invention can be realized in various forms and is not limited to embodiments stated herein.

### [Reference Examples 1-1 to 1-3]

The unit flexible device herein used was a polymer solar cell produced by Kolon Industries Inc.

Specifically, the unit flexible device had a width of 10 cm and a length of 10 cm, and a polyethylene terephthalate (PET) film was used as a flexible substrate.

A PET film was formed as a barrier film for blocking oxygen and/or moisture on an upper surface of the unit flexible device by roll-to-roll process. Then, first and second guide electrodes of the unit flexible device were punched to form a through hole and snap buttons having a male/female structure were connected and bonded to the unit flexible device having the corresponding bonding structure after forming the through holes of the first and second guide electrodes. In this case, the bonding method and direction between unit flexible devices and the number of the bonded unit flexible devices are shown in Table 1.

Current and voltage of the bonded flexible device module were measured using a Solar Simulator (Newport Corporation, Oriel Sol3A Class AAA Solar Simulator) and results are shown in the following Table 1.

**[Table 1]**

| Reference Example | Bonding method | Bonding direction | Number of unit flexible devices | Measurement current | Measurement voltage |
|---|---|---|---|---|---|
| Reference Example 1-1 | - | - | 1 | 70 mA | 8.0 V |
| Reference Example 1-2 | Snap button | - | 1 | 69 mA | 8.0 V |
| Reference Example 1-3 | Snap button | In series | 2 | 68 mA | 15.7 V |
| Reference Example 1-4 | Snap button | In parallel | 2 | 138 mA | 7.9 V |

### [Examples 1-1 to 1-15]

A silicone-coated release film was adhered to first and second guide electrode parts of the unit flexible device, excluding respective cell parts, which include organic active substances generating electric energy upon absorbing light and require barrier properties. A PET barrier film for blocking oxygen and/or moisture was formed by a roll-to-roll process on the upper surface of the unit flexible device. Then, the unit flexible device was cut and the non-bonded barrier film part was removed to expose the first and second guide electrodes to the outside.

Then, the remaining part excluding the guide electrode was shielded with a masking tape and the exposed part was then bar-coated with a composition for a conductive adhesive layer prepared by mixing 20 parts by weight of a metal powder of each of silver (Ag), nickel (Ni), copper (Cu), lead (Pb) and aluminum (Al) (all of them, KLK Inc.), with 100 parts by weight of a UV curable adhesive agent (Burim Chemical Co. Ltd., BRP-UV-1000 series, solid content 40% by weight) (using a Mayer Bar #18) and then dried using a UV curing machine to form a conductive adhesive layer. After removal of the masking tape, the unit flexible device provided with the conductive adhesive layer was bonded under conditions of bonding method, bonding direction and the number of bonded unit flexible devices shown in Table 2.

Current and voltage of the flexible device module produced by bonding were measured in the same manner as in Reference Example and results are shown in the following Table 2.

**[Table 2]**

| Example | Bonding method | Bonding direction | Number of unit flexible devices | Measurement current | Measurement voltage |
|---|---|---|---|---|---|
| Example 1-1 | silver, adhesive agent | - | 1 | 68mA | 7.9V |
| Example 1-2 | silver, adhesive agent | in series | 2 | 67mA | 15.8V |
| Example 1-3 | silver, adhesive agent | in parallel | 2 | 135mA | 7.9V |
| Example 1-4 | nickel, adhesive agent | - | 1 | 67mA | 7.8V |
| Example 1-5 | nickel, adhesive agent | in series | 2 | 67mA | 15.5V |
| Example 1-6 | nickel, adhesive agent | in parallel | 2 | 132mA | 7.8V |
| Example 1-7 | copper, adhesive agent | - | 1 | 69mA | 7.9V |
| Example 1-8 | copper, adhesive agent | in series | 2 | 69mA | 15.6V |
| Example 1-9 | copper, adhesive agent | in parallel | 2 | 137mA | 7.8V |
| Example 1-10 | lead, adhesive agent | - | 1 | 67mA | 7.8V |
| Example 1-11 | lead, adhesive agent | in series | 2 | 66mA | 15.5V |
| Example 1-12 | lead, adhesive agent | in parallel | 2 | 132mA | 7.8V |
| Example 1-13 | aluminum, adhesive agent | - | 1 | 69mA | 7.9V |
| Example 1-14 | aluminum, adhesive agent | in series | 2 | 67mA | 15.7V |
| Example 1-15 | aluminum, adhesive agent | in parallel | 2 | 133mA | 7.9V |

Examples 1-1 to 1-15 using an adhesive agent were expected to exhibit low current and voltage, as compared to Reference Example in which a snap button made of 100% of metal is used as a bonding part. On the other hand, as shown in Table 2, Examples 1-1 to 1-15 exhibited similar current and voltage to Reference Example using a snap button. In addition, Examples 1-1 to 1-15 did not generate high voltage between the connection part between snap buttons due to small distance between adhesive layers.

### [Examples 2-1 to 2-15]

A silicone-coated release film was adhered to first and second guide electrode parts of the unit flexible device, excluding respective cell parts, which include organic active substances generating electric energy upon absorbing light and require barrier property. A PET barrier film for blocking oxygen and/or moisture was formed by a roll-to-roll process on the upper surface of the unit flexible device. Then, the unit flexible device was cut and the non-bonded barrier film part was removed to expose the first and second guide electrodes to the outside.

Then, a part excluding the guide electrode was shielded with a masking tape and the exposed part was bar-coated with a composition for a conductive adhesive layer prepared by mixing 20 parts by weight of a metal powder of each of silver (Ag), nickel (Ni), copper (Cu), lead (Pb) and aluminum (Al) (all of them, KLK Inc.), with 100 parts by weight of a water-soluble sticking agent (Burim Chemical Co. Ltd., BAW-700 series, solid content: 50% by weight) (using a Mayer Bar #18) and then dried at 85°C in an oven for 10 minutes to form a conductive adhesive layer. After removal of the masking tape, the unit flexible device provided with the conductive adhesive layer was bonded under conditions of bonding method, bonding direction and the number of bonded unit flexible devices shown in Table 3.

Current and voltage of the flexible device module produced by bonding were measured in the same manner as in Reference Example and results are shown in the following Table 3.

**[Table 3]**

| Example | Bonding method | Bonding direction | Number of unit flexible devices | Measurement current | Measurement voltage |
|---|---|---|---|---|---|
| Example 2-1 | silver, sticking agent | - | 1 | 68mA | 8.0V |
| Example 2-2 | silver, sticking agent | in series | 2 | 68mA | 15.8V |
| Example 2-3 | silver, sticking agent | in parallel | 2 | 135mA | 7.9V |
| Example 2-4 | nickel, sticking agent | - | 1 | 68mA | 7.8V |
| Example 2-5 | nickel, sticking agent | in series | 2 | 67mA | 15.6V |
| Example 2-6 | nickel, sticking agent | in parallel | 2 | 133mA | 7.8V |
| Example 2-7 | copper, sticking agent | - | 1 | 69mA | 7.9V |
| Example 2-8 | copper, sticking agent | in series | 2 | 69mA | 15.6V |
| Example 2-9 | copper, sticking agent | in parallel | 2 | 138mA | 7.8V |
| Example 2-10 | lead, sticking agent | - | 1 | 67mA | 7.8V |
| Example 2-11 | lead, sticking agent | in series | 2 | 66mA | 15.5V |
| Example 2-12 | lead, sticking agent | in parallel | 2 | 132mA | 7.8V |
| Example 2-13 | aluminum, sticking agent | - | 1 | 69mA | 7.9V |
| Example 2-14 | aluminum, sticking agent | in series | 2 | 68mA | 15.8V |
| Example 2-15 | aluminum, sticking agent | in parallel | 2 | 133mA | 7.9V |

As can be seen from Table 3, when bonding is formed using a sticking agent, similar current and voltage characteristics to Reference Example 1 were obtained.

### [Examples 3-1 to 3-9]

A unit flexible device including a conductive bonding layer was produced in the same manner as in Example 1-1, except that metal oxide such as indium tin oxide (ITO), antimony tin oxide (ATO) or aluminum oxide (Alumina, Al₂O₃) (all of them, KLK products) was used instead of a metal powder. The unit flexible devices was bonded under conditions of bonding method, bonding direction and the number of bonded unit flexible devices shown in Table 4 below.

**[Table 4]**

| Example | Bonding method | Bonding direction | Number of unit flexible devices | Measurement current | Measurement voltage |
|---|---|---|---|---|---|
| Example 3-1 | ITO, adhesive agent | - | 1 | 67mA | 7.7V |
| Example 3-2 | ITO, adhesive agent | in series | 2 | 66mA | 15.3V |
| Example 3-3 | ITO, adhesive agent | in parallel | 2 | 131mA | 7.6V |
| Example 3-4 | ATO, adhesive agent | - | 1 | 66mA | 7.6V |
| Example 3-5 | ATO, adhesive agent | in series | 2 | 66mA | 15.1V |
| Example 3-6 | ATO, adhesive agent | in parallel | 2 | 130mA | 7.5V |
| Example 3-7 | Al₂O₃, adhesive agent | - | 1 | 64mA | 7.5V |
| Example 3-8 | Al₂O₃, adhesive agent | in series | 2 | 64mA | 15.0V |
| Example 3-9 | Al₂O₃, adhesive agent | in parallel | 2 | 127mA | 7.4V |

As can be seen from Table 4, a bonding method using an electrically conductive layer to which metal oxide is applied exhibited relatively serious current and voltage drop due to characteristics of metal oxide having lower electrical conductivity than a metal, as compared to Examples 1-1 to 1-15 using a metal powder, but exhibited sufficiently excellent current and voltage characteristics as a bonding part.

### [Examples 4-1 to 4-9]

A unit flexible device including a conductive bonding layer was produced in the same manner as in Example 1-1, except that carbon black (Unipetrol Inc., AC90), carbon nanotube (KLK Inc.), or graphene (KLK Inc.) was used instead of a metal powder. The unit flexible devices were bonded under conditions of bonding method, bonding direction and the number of bonded unit flexible devices shown in Table 5 below.

**[Table 5]**

| Example | Bonding method | Bonding direction | Number of unit flexible devices | Measurement current | Measurement voltage |
|---|---|---|---|---|---|
| Example 4-1 | carbon black, adhesive agent | - | 1 | 69mA | 7.9V |
| Example 4-2 | carbon black, adhesive agent | in series | 2 | 69mA | 15.6V |
| Example 4-3 | carbon black, adhesive agent | in parallel | 2 | 137mA | 7.8V |
| Example 4-4 | CNT, adhesive agent | - | 1 | 68mA | 7.8V |
| Example 4-5 | CNT, adhesive agent | in series | 2 | 68mA | 15.6V |
| Example 4-6 | CNT, adhesive agent | in parallel | 2 | 135mA | 7.8V |
| Example 4-7 | graphene, adhesive agent | - | 1 | 68mA | 8.0V |
| Example 4-8 | graphene, adhesive agent | in series | 2 | 67mA | 15.6V |
| Example 4-9 | graphene, adhesive agent | in parallel | 2 | 133mA | 7.8V |

As can be seen from Table 5, when a carbon structure having excellent electrical conductivity was used, superior current and voltage characteristics were obtained.

### [Examples 5-1 to 5-3] Conductive polymer test

A unit organic device was produced in the same manner as in Example 2-1, except that a conductive adhesive layer is produced by bar-coating a composition for a conductive adhesive layer prepared by mixing 100 parts by weight of a water-soluble PEDOT:PSS solution (Ditto Technology Inc.) with 40 parts by weight of a water-soluble sticking agent (Burim Chemical Co. Ltd. BAW-700 series) (using Mayer Bar #12). Then, the unit flexible device was bonded under conditions of bonding method, bonding direction and the number of bonded unit flexible devices shown in Table 6 below.

**[Table 6]**

| Example | Bonding method | Bonding direction | Number of unit flexible devices | Measurement current | Measurement voltage |
|---|---|---|---|---|---|
| Example 5-1 | PEDOT:PSS, adhesive agent | - | 1 | 64mA | 7.3V |
| Example 5-2 | PEDOT:PSS, adhesive agent | in series | 2 | 62mA | 14.2V |
| Example 5-3 | PEDOT:PSS, adhesive agent | in parallel | 2 | 121mA | 7.1V |

As can be seen from Table 6, Examples 5-1 to 5-3 using an electrically conductive layer, to which a conductive polymer was applied, as a bonding part during mixing with the adhesive agent, exhibited current and voltage drop due to change of molecular structure shape of doped PEDOT, as compared to Reference Example using a snap button as a bonding part and Examples 1-1 to 1-15 using a metal powder as a bonding part, but exhibited sufficient current and voltage characteristics during formation of the bonding part.

### [Examples 6-1 to 6-3] Bonding using magnetic

A unit flexible device was produced in the same manner as in Example 1-1, except that ferrite (CAD Co., Ltd.) was used instead of the metal powder.

The produced unit organic device was bonded under conditions of bonding method, bonding direction and the number of bonded unit flexible devices shown in Table 7 below.

**[Table 7]**

| Example | Bonding method | Bonding direction | Number of unit flexible devices | Measurement current | Measurement voltage |
|---|---|---|---|---|---|
| Example 6-1 | ferrite, adhesive agent | - | 1 | 66mA | 7. 8V |
| Example 6-2 | ferrite, adhesive agent | in series | 2 | 66mA | 15.5V |
| Example 6-3 | ferrite, adhesive agent | in parallel | 2 | 131mA | 7.8V |

Examples 6-1 to 6-3 including a conductive bonding layer using ferrite exhibited similar voltage and current characteristics to Reference Example and Examples.

Although the preferred embodiments of the present invention have been disclosed for illustrative purposes, those skilled in the art will appropriate that various modifications, additions and substitutions are possible, without departing from the scope of the invention as disclosed in the accompanying claims.

## Claims

1. A flexible device comprising:
a substrate (10);
a unit cell being disposed on the substrate and generating electric energy; and
first and second current collectors (30, 40) disposed at outer side surfaces of the unit cell on the substrate,
wherein at least one of the first and second current collectors includes a conductive bonding layer (50, 60) including a conductive material and any one bonding material of an adhesive agent and a sticking agent,
wherein the current collector (30, 40) further comprises a guide electrode formed on an outer surface of a first or second electrode (21, 22) and extends therefrom and wherein the conductive bonding layer (50, 60) is disposed on at least one of the first and second electrodes (21, 22).

2. The flexible device according to claim 1, wherein the conductive bonding layer is disposed on the first or second current collector.

3. The flexible device according to claim 1, wherein the conductive bonding layer has a shape selected from the group consisting of a film, a stripe and an island.

4. The flexible device according to claim 1, wherein the conductive material comprises at least one selected from the group consisting of a metal powder, a carbonaceous material, metal oxide, a conductive polymer and a derivative thereof, a magnetic material and a mixture thereof.

5. The flexible device according to claim 1, wherein the bonding material is selected from the group consisting of an epoxy resin, a polyester resin, an acrylic resin, a phenolic resin, a vinyl resin, polyimide, polybenzimidazole, a silicone-based resin, a urethane resin, a melamine urea resin and a mixture thereof.

6. The flexible device according to claim 1, wherein the conductive bonding layer is formed on the guide electrode.

7. The flexible device according to claim 1, further comprising an oxygen and/or moisture barrier layer on the unit cell,
wherein the first and second current collectors are exposed from the oxygen and/or moisture barrier layer.

8. The flexible device according to claim 1, wherein the substrate is a flexible substrate selected from the group consisting of a metal foil, an inorganic thin film, a polymer film, a fibrous material, and a composite of a glass fiber and a polymer.

9. A flexible device module comprising two or more flexible devices including the flexible device according to claim 1,
wherein the flexible devices are electrically bonded by a conductive bonding layer.

10. The flexible device module according to claim 9, wherein the flexible device comprises conductive bonding layers on the respective first and second current collectors, and
one of the conductive bonding layers formed on the first and second current collectors comprises a magnetic material and the other conductive bonding layer comprises a conductive material including a metal powder or a metal thin film.

11. The flexible device module according to claim 9, wherein the flexible device comprises conductive bonding layers disposed on the respective first and second current collectors, and
one of the conductive bonding layers formed on the first and second current collectors comprises a conductive material and a bonding material including an adhesive agent or sticking agent, and the other conductive bonding layer comprises a conductive material and a release agent.

12. The flexible device module according to claim 9, wherein the flexible devices are bonded in series or in parallel.

13. The flexible device module according to claim 9, wherein the bonding between the flexible devices is removable temporary bonding.

## Patentansprüche

1. Flexible Vorrichtung, umfassend:
ein Substrat (10);
eine Elementarzelle, die auf dem Substrat angeordnet ist und elektrische Energie erzeugt; und
einen ersten und einen zweiten Stromsammler (30, 40),
die an den äußeren Seitenflächen der Elementarzelle auf dem Substrat angeordnet sind,
wobei mindestens einer von dem ersten und dem zweiten Stromsammler eine leitende Bindeschicht (50, 60) umfasst, die ein leitendes Material und jedes beliebige Bindematerial eines Klebemittels und eines Haftmittels umfasst,
wobei der Stromsammler (30, 40) ferner eine Führungselektrode umfasst, die an einer Außenfläche einer ersten oder einer zweiten Elektrode (21, 22) gebildet ist und sich davon erstreckt und wobei die leitende Bindeschicht (50, 60) auf mindestens einer der ersten und der zweiten Elektrode (21, 22) angeordnet ist.

2. Flexible Vorrichtung nach Anspruch 1, wobei die leitende Bindeschicht auf dem ersten oder dem zweiten Stromsammler angeordnet ist.

3. Flexible Vorrichtung nach Anspruch 1, wobei die leitende Bindeschicht eine Form aufweist, die aus der Gruppe bestehend aus einem Film, einem Streifen und einer Insel ausgewählt ist.

4. Flexible Vorrichtung nach Anspruch 1, wobei das leitende Material mindestens ein Material umfasst, das aus der Gruppe bestehend aus einem Metallpulver, einem kohlenstoffhaltigen Material, Metalloxid, einem leitenden Polymer und einem Derivat davon, einem magnetischen Material und einem Gemisch davon ausgewählt ist.

5. Flexible Vorrichtung nach Anspruch 1, wobei das Bindematerial aus der Gruppe bestehend aus einem Epoxidharz, einem Polyesterharz, einem Acrylharz, einem Phenolharz, einem Vinylharz, Polyimid, Polybenzimidazol, Harz auf Silikonbasis, einem Urethanharz, einem Melaminureaharz und einem Gemisch davon ausgewählt ist.

6. Flexible Vorrichtung nach Anspruch 1, wobei die leitende Bindeschicht auf der Führungselektrode gebildet ist.

7. Flexible Vorrichtung nach Anspruch 1, ferner umfassend eine Sauerstoff- und/oder Feuchtigkeitssperrschicht auf der Elementarzelle,
wobei der erste und der zweite Stromsammler gegenüber der Sauerstoff- und/oder Feuchtigkeitssperrschicht freiliegen.

8. Flexible Vorrichtung nach Anspruch 1, wobei das Substrat ein flexibles Substrat ist, das aus der Gruppe bestehend aus einer Metallfolie, einem anorganischen Dünnfilm, Polymerfilm, einem Fasermaterial und einem Verbundstoff aus einer Glasfaser und einem Polymer ausgewählt ist.

9. Flexibles Vorrichtungsmodul, umfassend zwei oder mehrere flexible Vorrichtungen, die die flexible Vorrichtung nach Anspruch 1 umfassen,
wobei die flexiblen Vorrichtungen durch eine leitende Bindeschicht elektrisch gebunden sind.

10. Flexibles Vorrichtungsmodul nach Anspruch 9, wobei die flexible Vorrichtung leitende Bindeschichten auf dem jeweiligen ersten und zweiten Stromsammler umfasst, und
eine der leitenden Bindeschichten, die auf dem ersten und zweiten Stromsammler gebildet sind, ein magnetisches Material umfasst, und die andere leitende Bindeschicht ein leitendes Material umfasst, das ein Metallpulver oder einen Metalldünnfilm umfasst.

11. Flexibles Vorrichtungsmodul nach Anspruch 9, wobei die flexible Vorrichtung leitende Bindeschichten umfasst, die auf dem jeweiligen ersten und zweiten Stromsammler angeordnet sind, und
eine der leitenden Bindeschichten, die auf dem ersten und zweiten Stromsammler gebildet sind, ein leitendes Material und ein Bindematerial umfasst, das ein Klebemittel oder Haftmittel umfasst, und die andere leitende Bindeschicht ein leitendes Material und ein Lösemittel umfasst.

12. Flexibles Vorrichtungsmodul nach Anspruch 9, wobei die flexiblen Vorrichtungen in Reihe oder parallel gebunden sind.

13. Flexibles Vorrichtungsmodul nach Anspruch 9, wobei die Bindung zwischen den flexiblen Vorrichtungen eine lösbare temporäre Bindung ist.

## Revendications

1. Dispositif flexible, comprenant :
un substrat (10) ;
une cellule unitaire étant disposée sur le substrat et générant de l'énergie électrique ; et
des premier et second collecteurs de courant (30, 40) disposés sur des surfaces latérales externes de la cellule unitaire sur le substrat,
dans lequel au moins l'un des premier et second collecteurs de courant comporte une couche de liaison conductrice (50, 60) comportant un matériau conducteur et un quelconque matériau de liaison parmi un agent adhésif et un agent collant,
dans lequel le collecteur de courant (30, 40) comprend en outre une électrode de guidage formée sur une surface externe d'une première ou d'une seconde électrode (21, 22) et s'étend à partir de celle-ci et dans lequel la couche de liaison conductrice (50, 60) est disposée sur au moins l'une des première et seconde électrodes (21, 22).

2. Dispositif flexible selon la revendication 1, dans lequel la couche de liaison conductrice est disposée sur le premier ou le second collecteur de courant.

3. Dispositif flexible selon la revendication 1, dans lequel la couche de liaison conductrice a une forme choisie dans le groupe constitué d'un film, d'une bande et d'un îlot.

4. Dispositif flexible selon la revendication 1, dans lequel le matériau conducteur comprend au moins un matériau choisi dans le groupe constitué d'une poudre métallique, d'un matériau carboné, d'un oxyde métallique, d'un polymère conducteur et d'un dérivé de celui-ci, d'un matériau magnétique et d'un mélange de ceux-ci.

5. Dispositif flexible selon la revendication 1, dans lequel le matériau de liaison est choisi dans le groupe constitué d'une résine époxy, d'une résine polyester, d'une résine acrylique, d'une résine phénolique, d'une résine vinyle, d'un polyimide, d'un polybenzimidazole, d'une résine à base de silicone, d'une résine uréthane, d'une résine mélamine-urée et d'un mélange de ceux-ci.

6. Dispositif flexible selon la revendication 1, dans lequel la couche de liaison conductrice est formée sur l'électrode de guidage.

7. Dispositif flexible selon la revendication 1, comprenant en outre une couche barrière contre l'oxygène et/ou l'humidité sur la cellule unitaire,
dans lequel les premier et second collecteurs de courant sont exposés à partir de la couche barrière contre l'oxygène et/ou l'humidité.

8. Dispositif flexible selon la revendication 1, dans lequel le substrat est un substrat flexible choisi dans le groupe constitué d'une feuille métallique, d'un film mince inorganique, d'un film polymère, d'un matériau fibreux et d'un composite d'une fibre de verre et d'un polymère.

9. Module de dispositif flexible comprenant deux dispositifs flexibles ou plus comportant le dispositif flexible selon la revendication 1,
dans lequel les dispositifs flexibles sont liés électriquement par une couche de liaison conductrice.

10. Module de dispositif flexible selon la revendication 9, dans lequel le dispositif flexible comprend des couches de liaison conductrices sur les premier et second collecteurs de courant respectifs, et
l'une des couches de liaison conductrices formée sur les premier et second collecteurs de courant comprend un matériau magnétique et l'autre couche de liaison conductrice comprend un matériau conducteur comportant une poudre métallique ou un film mince métallique.

11. Module de dispositif flexible selon la revendication 9, dans lequel le dispositif flexible comprend des couches de liaison conductrices disposées sur les premier et second collecteurs de courant respectifs, et
l'une des couches de liaison conductrices formée sur les premier et second collecteurs de courant comprend un matériau conducteur et un matériau de liaison comportant un agent adhésif ou un agent collant, et l'autre couche de liaison conductrice comprend un matériau conducteur et un agent de démoulage.

12. Module de dispositif flexible selon la revendication 9, dans lequel les dispositifs flexibles sont liés en série ou en parallèle.

13. Module de dispositif flexible selon la revendication 9, dans lequel la liaison entre les dispositifs flexibles est une liaison temporaire amovible.
